Europäisches Patentamt

European Patent Office

Office européen des brevets

(11) Publication number: **0 399 372**
**A2**

(12) ## EUROPEAN PATENT APPLICATION

(21) Application number: **90109347.6**

(51) Int. Cl.5: **G02F 1/133**

(22) Date of filing: **17.05.90**

(30) Priority: **22.05.89 JP 128032/89**

(43) Date of publication of application:
**28.11.90 Bulletin 90/48**

(84) Designated Contracting States:
**DE FR GB**

(71) Applicant: **Citizen Watch Co. Ltd.**
**1-1, 2-chome, Nishi-Shinjuku**
**Shinjuku-ku Tokyo(JP)**

(72) Inventor: **Yoshida, Masaru**
**1-34-38, Hagiyama-cho**
**Higashimurayama-shi, Tokyo(JP)**
Inventor: **Hayashi, Yasuhiro**
**2245-20, Kitatokorozawa-cho**
**Tokorozawa-shi, Saitama(JP)**

(74) Representative: **Heim, Hans-Karl, Dipl.-Ing. et al**
**c/o Weber & Heim Hofbrunnstrasse 36**
**D-8000 München 71(DE)**

(54) **Liquid crystal display.**

(57) A liquid crystal display having an LCD cell composed of a common glass, a segment glass and a liquid crystal sealed therebetween. Electrodes are provided on the surfaces of the common glass and the segment glass to form a matrix. Each electrode terminal is connected to a circuit substrate. The circuit substrate is divided into a common circuit substrate and a segment circuit substrate. The end portions of these substrates are connected through folded flat cables in the state in which the end portion thereof overlap with the LCD cell. The division of the circuit substrate reduces the total thickness of the display and overlapping arrangement restricts the necessary displaying area to the minimum.

FIG. 1

# LIQUID CRYSTAL DISPLAY

## BACKGROUND OF THE INVENTION

### Field of the Invention

The present invention relates to a liquid crystal display and, more particularly, to the arrangement of an LCD cell and a circuit substrate.

### Description of the Related Art

CRT's are used for broadcasting television sets, computers and the output means of various monitors. Recently, various types of flat displays are used for the displays of these apparatuses and contribute to the reduction in size and thickness of these apparatuses. Especially, in order to reduce the size of a computer so as to be portable, such a flat display is indispensable, and various types of flat displays such as a liquid crystal display, plasma display and fluorescent display are proposed. Among these, a liquid crystal display (hereinunder referred to as "LCD") is widely used because of its small power consumption, low price and stable displaying operation. By incorporating an LCD into the cover body of a portable computer, a very handy and convenient computer is obtained.

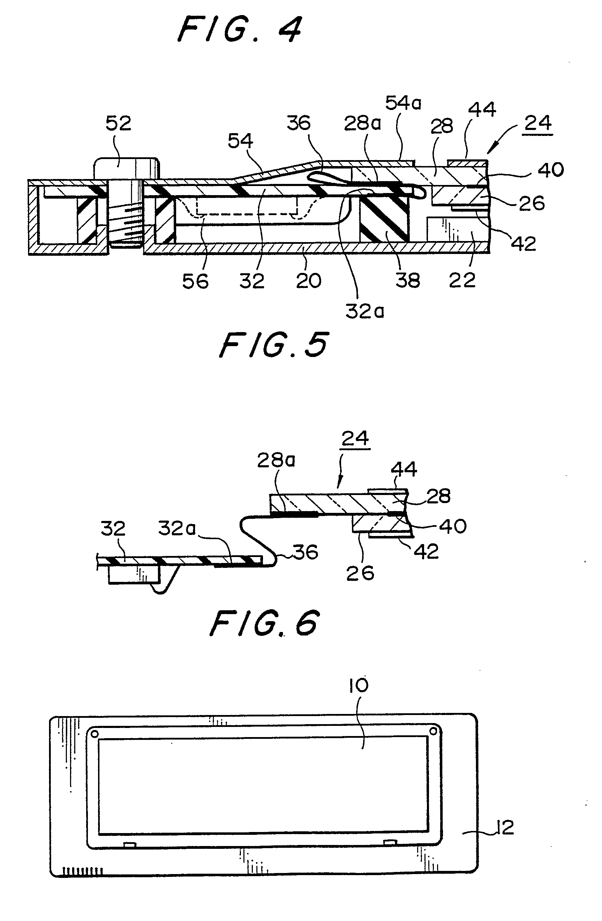

Fig. 6 shows a conventional LCD. A known LCD cell 10 is connected to a circuit substrate 12.

The LCD cell 12 is composed of two glass plates with common electrodes and segment electrodes respectively provided thereon in a matrix and a liquid crystal sealed between the glass plates. A polarizing plate is usually provided on the surface of each glass plate.

Predetermined display circuit elements are mounted on the back side of the circuit substrate 12 in order to supply a predetermined driving voltage to the common electrodes and the segment electrodes. By connecting the LCD cell 10 and the circuit substrate 12 by pins or a conductive rubber, a predetermined driving voltage is suppled to the LCD cell 10, thereby achieving a desired displaying operation.

Minimization of the apparatus by directly mounting an IC on an LCD cell is conventionally proposed. For example, in a COG (chip-on-glass) system, an IC is directly mounted on the glass surface of an LCD cell to reduce the size and thickness of the apparatus.

A method of minimizing the apparatus by integrally providing an LCD cell and an IC mounted on an FPC by an TAB system is also proposed.

In such a conventional LCD, however, since the LCD cell 10 is laminated on the display circuit substrate 12 as a whole, as is obvious from Fig. 6, the thickness still remains a problem in a portable computer which is strictly required to be small and thin.

In other words, a satisfactory display which is thin enough to be incorporated into the cover body of a computer carried within an attache case or the like has not been produced.

Japanese Utility Model Application No. 12380/1989 and Japanese Patent Laid-Open No 32389/1990 disclose the structure in which the LCD cell and the circuit substrate are connected through a film-like connector but any concrete combination and arrangement of both members is not described.

In the conventional COG system, a metal film is necessary not only for the ITO of the LCD cell but also for the input pattern for the IC in order to reduce the input resistance of the IC, resulting in the rise in the cost of the LCD cell. In addition, in the conventional COG system, if even a part of the IC mounted on the LCD cell becomes defective, it is necessary to displace the LCD cell itself, so that if a defect is found after such a defective IC is mounted, the production yield is greatly lowered. Furthermore, such an integrally provided cell requires a separate input substrate.

In the conventional TAB system, it is necessary to form a bumper for connecting the LCD cell, thereby raising the FPC cost. It also requires an input substrate.

## SUMMARY OF THE INVENTION

Accordingly, it is an object of the present invention to eliminate the above-described problems in the related art and to provide an improved LCD having a further reduced thickness without lowering the functional characteristics.

To achieve this aim, the present invention is characterized in that the display circuit substrate is divided into a common circuit substrate and a segment circuit substrate, each of the circuit substrates is disposed in correspondence with the electrode terminal edges of the LCD cell, and is connected to the LCD cell by a flat cable.

According to the present invention, the LCD cell and each of the circuit substrates are disposed substantially in the same plane. Furthermore, each circuit substrate is disposed such that the end portion thereof overlaps with the end portion of the corresponding glass end portion of the LCD cell, and the flat cable which electrically connects the circuit substrate and the LCD cell is folded back singly or doubly between the LCD cell and the circuit substrate.

Therefore, according to the present invention, it is unnecessary to provide a space between the liquid cell and the circuit substrate and it is possible to obtain a very compact LCD horizontally as well as vertically.

In the present invention, the LCD cell and each circuit substrate are fixed on a predetermined holder, and each circuit substrate is disposed in alignment in the direction of thickness such that the end portion of the LCD cell overlaps with the end portion of each circuit substrate while connecting the LCD cell and each circuit substrate by the flat cable, as described above. It is therefore possible to greatly reduce the thickness as a whole and to produce a thin LCD which is suitable for a portable computer.

The above and other objects, features and advantages of the present invention will become clear from the following description of the preferred embodiment thereof, taken in conjunction with the accompanying drawings.

BRIEF DESCRIPTION OF THE DRAWINGS

Fig. 1 is a partially exploded plan view of an embodiment of an LCD according to the present invention;

Fig. 2 is a sectional view of the main part of the embodiment shown in Fig. 1, showing the state in which the common electrode terminals are connected to the circuit substrate;

Fig. 3 is an explanatory view of the flat cable shown in Fig. 2 in the state of being folded back;

Fig. 4 is a sectional view of the main part of the embodiment shown in Fig. 1, showing the state in which the segment electrode terminals are connected to the circuit substrate;

Fig. 5 is an explanatory view of the flat cable shown in Fig. 4 in the state of being folded back; and

Fig. 6 is a plan view of a conventional LCD.

DESCRIPTION OF THE PREFERRED EMBODIMENT

A preferred embodiment of the present invention will be explained hereinunder with reference to the accompanying drawings.

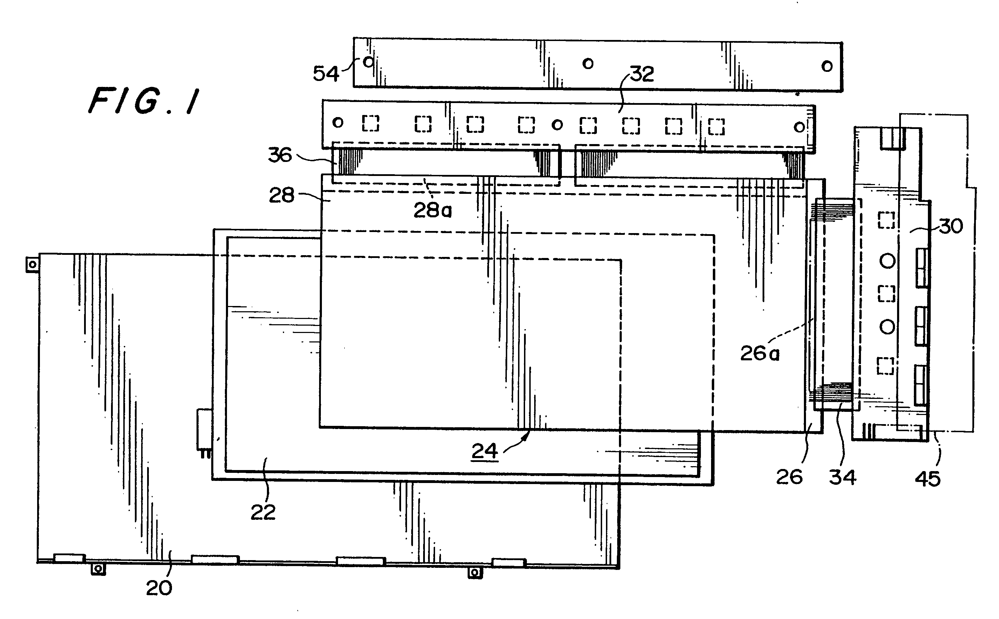

Fig. 1 is a partially exploded plan view of an LCD according to the present invention.

An LCD in this embodiment is a display equipped with a backlight, and is composed of an electroluminescence (hereinunder referred to as "EL") plate 22 which constitutes the backlight, an LCD cell 24 placed on the EL plate 22, a cell presser and a common circuit substrate 30 for fixing these members to a holder case 20 by screwing.

The LCD cell 24 like the conventional LCD cell 12 is composed of a common glass 26, a segment glass 28 laminated on each other with a liquid crystal sealed therebetween, and a polarizing glass placed on the surfaces of the glasses 26, 28, as will be described later.

Common electrodes are disposed on the surface of the common glass 26, as well known, and the common electrode terminals are extended to the periphery, the right-hand end portion 26a in Fig. 1, of the common glass 26. Similarly, known segment electrodes are disposed on the surface of the segment glass 28 and the segment electrode terminals are extended to the periphery of the segment glass 28 indicated by the numeral 28a in Fig. 1.

The present invention is characterized in that the display circuit substrate is divided into the common circuit substrate 30 and the segment circuit substrate 32. Both substrates 30, 32 are disposed at the positions opposite to the electrode terminals 26a, 28a, respectively, of the common glass 26 and the segment glass 28, respectively.

In this embodiment, the length of the segment circuit substrate 32 is set at the value substantially the same as the width of the matrix of the terminals 28a of the segment glass 28. On the other hand, the length of the common circuit substrate 30 is set at the value substantially the same as the sum of the width of the matrix of the terminals 26a of the common glass 26 and the width of the segment circuit substrate 32. In this way, the assembled LCD is so designed as to have a rectangular shape having the minimum area as a total dimension.

Each of the common circuit substrate 30 and the segment circuit substrate 32 are composed of a heat-resistant resin substrate plated with copper on both sides, and an LCD driver IC is mounted on the under surface thereof. These driver IC's are mounted on the substrate in the form of a bare chip, and sealed with a resin after wire bonding, thereby making the horizontal space on each substrate small. On the pattern on the upper surface of each substrate. Wirings for input signals and the power source are mounted, and are electrically connected to each driver IC through through holes, thereby reducing the widths of the circuit substrates 30, 32 to the minimum.

The common electrode terminals 26a and the common circuit substrate 30 are electrically connected by a flat cable 34, and the segment electrode terminals 28a and the segment circuit substrate 32 are similarly electrically connected by a flat cable 36.

As well known, the flat cable 34 (36) is also known as a heat-sealing connector. A printed wiring of silver and graphite is provided on a thin plastic polyester film substrate of 25 to 50 μm thick, and a hot-melt adhesive is printed at the electrically connecting portions with the electrode terminals 26a (28a) and the circuit substrate 30 (32). Such a heat-sealing connector allows the cable itself to be freely folded and easily adhered by a simple operation, thereby forming a connecter having reliability in connection at a low cost.

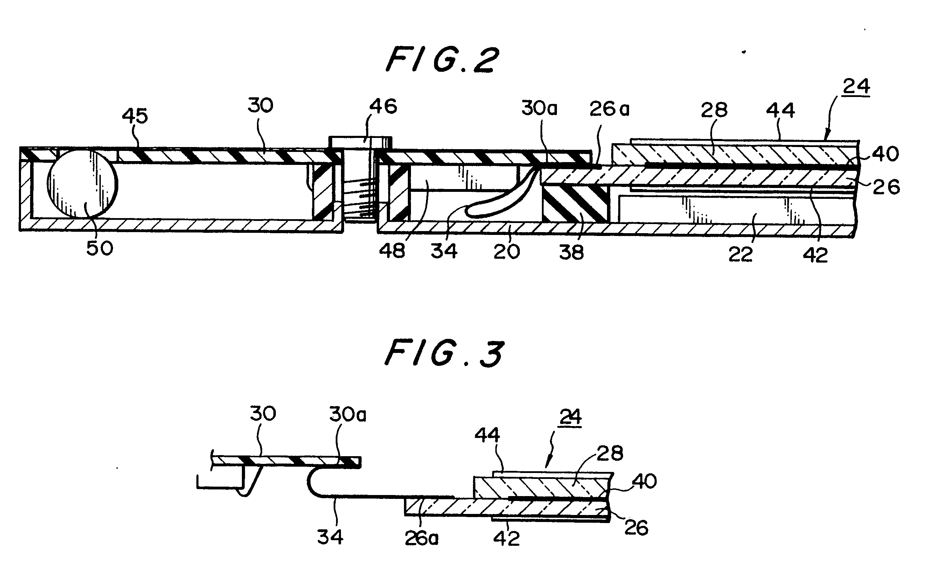

Fig. 2 shows in section the state in which the common electrode terminals 26a are connected to the common circuit substrate 30.

In Fig. 2, the common glass 26 is fixed on the holder case 20 through a cushion rubber 38. An LCD 40 is sealed between the common glass 26 and the segment glass 28, and polarizing plates 42, 44 are laminated on the surfaces of the glasses 26, 28, respectively. In the gap between the holder case 20 and the LCD cell 24 formed by the cushion rubber 38, the EL plate 22 is removably disposed as a backlight.

The ordinary life of EL is several thousand hours and the replacement of the EL during use is inevitable. In the structure of this embodiment, it is easy to replace the EL disposed in the gap from the opening on the left-hand side surface of the holder, for example, without removing the screw, etc.

The end portion of the holder case 20 is further extended to the left-hand side in Fig. 2 and the common circuit substrate 30 is fixed to the holder case 20 by a screw 46. On the common circuit substrate 30, display circuit elements 48 such as a common driving IC are mounted in such a manner as to face the back surface aide of the LCD in this embodiment. Even after the assembly of the LCD, the thickness of the circuit substrate 30 with the circuit elements mounted thereon does not exceed the thickness of the LCD cell 24. Thus, it is possible to greatly reduce the thickness of the LCD in the present invention.

In the case in which a comparatively large circuit element such as a capacitor indicated by the numeral 50 in Fig. 2 is mounted on the common circuit substrate 30, it is also possible to incorporate a thick element such as the element 50 into the display without increasing the thickness of the LCD by laminating the EL plate 22 for a backlight on the back surface of the LCD cell 24 in accordance with the arrangement of the present invention, as shown in Fig. 2.

As described above, the circuit terminal 26a of the common glass 26 and the common circuit substrate 30 are electrically connected by the flat cable 34. One end of the flat cable 34 is connected to the common circuit terminal 26a and the other end thereof is connected to the terminal provided at the end portion 30a of the circuit substrate 30, as shown in Fig. 3.

After the completion of these members, the end portion 30a of the common circuit terminal 30 is disposed in such a manner as to overlap with the end portion of the common glass 26, namely, the common electrode terminals 26a in this embodiment. In this state, the common circuit substrate 30 and a shield plate 45 are firmly fixed to the holder case 20 by the screw 46, and at the same time the LCD cell 24 is firmly fixed to and held by the holder case 20.

One end of the shield plate 45 is connected to the grounding terminal of the common circuit substrate 30. Since the shield plate 45 and the holder case 20 are electrically connected to each other through the screw 46, the shield plate 45 covers the common circuit plate 30. thereby preventing the external leakage of electromagnetic noise.

In this state, the flat cable 34 folded back singly connects the common circuit substrate 30 to the electrode terminals 26a of the common glass 26.

According to the present invention, one part of the LCD cell overlaps with one part of the common circuit substrate 30 at the end portions thereof, as is clear from Fig. 2, thereby enabling the great reduction in a horizontal space as well as in a vertical space.

Fig. 4 shows the state in which the segment electrode terminals 28a of the segment glass 28 are connected to the segment circuit substrate 32. The segment circuit substrate 32 is firmly fixed to the holder case 20 by a screw 52. In this embodiment, a receiver plate 54 is placed on the upper surface of the segment circuit substrate 32. The receiver plate 54 is fixed to the holder case 20 integrally with the segment circuit plate 32 by the screw 52, thereby obtaining a firm fixed connected structure. One end 54a of the receiver plate 54 is extended to the end portion of the segment glass 28 of the LCD cell 24 so as to firmly fix the LCD cell 24 to the holder 20. The receiver plate 54 and the holder case 20 are electrically connected to each other through the screw 52, thereby effectively shielding the segment circuit substrate 32 which produces electromagnetic noise.

On the segment circuit substrate 32, display circuit elements 56 such as a segment driving IC are mounted in such a manner as to face the back side of the LCD cell 24 in this embodiment. The receiver plate 54 has substantially the same thickness as the polarizing plate 44. It is therefore possible to accommodate the circuit substrate and the respective display circuit elements mounted thereon without increasing the thickness of the LCD.

Fig. 5 shows the state in which the segment glass 28 and the segment circuit substrate 32 are electrically connected merely by the flat cable 36, in the same way as shown in Fig. 1. As is obvious from Fig. 5, both the segment circuit substrate 32 and the common circuit substrate 30 are disposed at the sectional position at which the IC mounted on each substrate substantially agrees with the common glass 26 of the LCD cell 24, and the connector electrodes for the respective substrates are provided on the same side on which the IC's are provided. The electrode terminals 28a of the segment glass 28 face downward in Fig. 5, and similarly, the connector electrodes 32a of the segment circuit substrate 32 face downward. In order to dispose these electrodes 28a and 32a at the connecter end portion 32a of the segment circuit substrate 32 in the state of overlapping with the segment glass 28, as shown in Fig. 4, both electrodes 28a and 32a are connected in an electrically and mechanically stable state by folding back the flat cable doubly, as shown in Fig. 4.

In this way, the LCD cell 24 is fixed to the metal holder case 20 together with the circuit substrates 30 and 32, and the holder case 20 is further screwed to the box body of a computer at fixing tabs 20a. As a result, the external force applied to the computer box body is received by the metal holder case 20 and is prevented from influencing the LCD cell or the circuit substrates 30, 32.

Thus, the circuit substrates 30, 32 with the circuit elements mounted thereon are arranged substantially in the same plane with the liquid cell 24, and a part thereof overlaps with the glass which constitutes the liquid cell. It is therefore possible to produce a small-sized thin LCD with the horizontal space reduced to the minimum.

In this embodiment, the LCD cell is composed of a double polarizing plate type cell equipped with a backlight, but the type of the cell itself is not restricted and any given cell may be adopted.

As described above, according to the present invention, since the circuit substrate is divided into a common circuit substrate and a segment circuit substrate, and both substrates are connected to the electrode terminals of the LCD cell by flat cables and are disposed such that the end portions of the circuit substrates overlap with the end portions of the corresponding LCD glasses, it is possible to produce an LCD with the thickness and the horizontal dimension greatly reduced. Thus, it is possible to provide a display which is suitable especially for a portable computer at a low cost.

While there has been described what is at present considered to be a preferred embodiment of the invention, it will be understood that various modifications may be made thereto, and it is intended that the appended claims cover all such modifications as fall within the true spirit and scope of the invention.

## Claims

1. A liquid crystal display (hereinunder referred to as "LCD") comprising:
an LCD cell including a common glass with common electrodes disposed on the surface thereof in such a manner as to extend to the periphery thereof, a segment glass with segment electrodes disposed on the surface thereof in such a manner as to extend to the periphery thereof, and a liquid crystal held between said common glass and said segment glass;
a circuit substrate with display circuit elements mounted thereon which is connected to the electrode terminals of said LCD cell;
said circuit substrate being divided into a common circuit substrate and a segment circuit substrate which are connected to the corresponding end portions of said common substrate and said segment substrate, respectively, of said LCD cell by flat cables; and
the end portions of said common circuit substrate and said segment circuit substrate overlapping with the end portions of said common glass and said segment glass, respectively, through said flat cables.

2. An LCD according to Claim 1, wherein said common circuit substrate and said segment circuit substrate are opposed to the electrode terminals of said common glass and said segment glass, respectively.

3. An LCD according to Claim 2, wherein the length of said segment circuit substrate is set at a value equal to the width of the matrix of said electrode terminals of said segment glass and the length of said common circuit substrate is set at a value equal to the sum of the width of the matrix of said electrode terminals of said common glass and the length of said segment circuit substrate.

4. An LCD according to Claim 1, wherein each of said common circuit substrate and said segment circuit substrate is composed of a heat-resistant resin substrate plated with copper on both sides thereof.

5. An LCD according to Claim 4, wherein an LCD driver IC is mounted on the under surface of each of said common circuit substrate and said segment circuit substrate.

6. An LCD according to Claim 5, wherein said driver IC is mounted on each of said circuit substrates in the form of a bare chip and sealed with a resin after wire bonding.

7. An LCD according to Claim 4, wherein wirings for input signals and a power source are mounted on the upper surface of each of said circuit substrates and are electrically connected to each of said driver IC's through a through hole formed in each of said circuit substrates.

8. An LCD according to Claim 1, wherein each of said flat cables is composed of a heat-sealing connector including a printed wiring of silver and graphite provided on a thin plastic polyester film substrate of 25 to 50 $\mu$m thick, and a hot-melt adhesive is printed at the electrically connecting portions with said electrode terminals and said circuit substrate.

9. An LCD according to Claim 1, wherein said common glass of said LCD cell is fixed to the inside of a holder case through a cushion rubber.

10. An LCD according to Claim 9, wherein an electroluminescence (hereinunder referred to as "EL") plate for a backlight is removably provided at a gap between said holder case and said LCD cell in said holder case formed by said cushion rubber.

11. An LCD according to Claim 10, wherein said EL plate is fixed to said holder case by screwing.

12. An LCD according to Claim 9, wherein said common circuit substrate is fixed to said holder case by screwing.

13. An LCD according to Claim 9, wherein a shield plate for covering said common circuit substrate so as to prevent the external leakage of electromagnetic noise is disposed on the surface of said common circuit substrate such that one end of said shield plate is connected to the grounding terminal of said common circuit substrate, and said common circuit substrate and said shield plate are electrically connected to said holder case through a screw.

14. An LCD according to Claim 13, wherein said common circuit substrate and said electrode terminals of said common glass are connected to each other by said flat cable which is folded back singly.

15. An LCD according to Claim 13, wherein a receiver plate is disposed on the said segment circuit substrate, and said segment circuit substrate and said receiver plate are integrally fixed to said holder case through a screw.

16. An LCD according to Claim 15, wherein one end of said receiver plate is extended to the end portion of said segment glass of said LCD cell, whereby said LCD cell is held by said holder case by said screw and said receiver plate and said holder case are electrically connect with each other through said holder case.

17. An LCD according to Claim 16, wherein display circuit elements including a segment driving IC are disposed on said segment circuit substrate in such a manner as to face the back surface of said LCD.

18. An LCD according to Claim 17, wherein said segment circuit substrate and said common circuit substrate are disposed such that said elements mounted on each of said substrates are substantially at the same level with said common glass of said LCD cell, and said electrodes are provided on the same side of each of said circuit substrates on which said elements are mounted.

19. An LCD according to Claim 18, wherein said electrode terminals of said segment glass and said segment circuit substrate are provided on the respective bottom surface sides, and said electrode terminals are connected to each other by said flat cable which is folded back doubly between said segment glass and said segment circuit substrate.

FIG. 1

EP 0 399 372 A2

FIG.2

FIG.3

# FIG. 4

# FIG.5

# FIG.6